# EUROPÄISCHE PATENTANMELDUNG

(11) **EP 3 879 277 A1**
(43) Veröffentlichungstag der Anmeldung: **15.09.2021**
(21) Anmeldenummer: 20162301.4
(22) Anmeldetag: 11.03.2020
(51) Int. Cl.: G01R 15/04, G01R 27/18, G01R 27/02

(54) **VERFAHREN UND PHOTOVOLTAIK-WECHSELRICHTER ZUR BESTIMMUNG DES ISOLATIONSWIDERSTANDS EINER PHOTOVOLTAIK-ANLAGE GEGEN ERDE**

(71) Anmelder: FRONIUS INTERNATIONAL GmbH, 4643 Pettenbach (AT)
(72) Erfinder: FISCHEREDER, Franz, 4600 Wels (AT); MÜHLBERGER, Andreas M., 4600 Wels (AT); PIRCHENFELLNER, Jürgen, 4600 Wels (AT); LUGER, Andreas, 4600 Wels (AT)
(74) Vertreter: SONN Patentanwälte OG

(57) **Zusammenfassung**

Die Erfindung betrifft ein Verfahren und einen Photovoltaik-Wechselrichter (2) zur Bestimmung des Isolationswiderstands (Riso) der Photovoltaik-Anlage (1) gegen Erde (PE). Erfindungsgemäß ist die Messeinrichtung (13) zur Betätigung eines Eingangskurzschlussschalters (S_{Boost}) zum Kurzschließen des DC-Eingangs (3) bei geöffnetem AC-Trenner (8) ausgebildet, wodurch die Zwischenkreisspannung (U_{ZK}) in umgekehrter Richtung an den DC-Eingang (3) anlegbar ist, und die Messeinrichtung (13) zur Erfassung jeweils einer Messspannung (U_{M1}, U_{M2}) bei geöffnetem und geschlossenem Schalter (Sᵢₛₒ) des Spannungsteilers (14) und der Bestimmung des Isolationswiderstands (Rᵢₛₒ) aus den Messwerten der beiden erfassten Messspannungen (U_{M1}, U_{M2}) bei geöffnetem und geschlossenem Schalter (Sᵢₛₒ) des Spannungsteilers (14) eingerichtet.

## Beschreibung

Die Erfindung betrifft ein Verfahren zur Bestimmung des Isolationswiderstands einer Photovoltaik-Anlage gegen Erde, mit einem Photovoltaik-Wechselrichter mit zumindest einem DC-Eingang zur Verbindung mit zumindest einem Photovoltaik-Modul oder einem String mehrerer Photovoltaik-Module, einem DC/DC-Wandler mit einer Eingangsdiode, einem Zwischenkreis, einem DC/AC-Wandler, einem AC-Trenner, einem AC-Ausgang zur Verbindung mit einem Versorgungsnetz und bzw. oder Verbraucher, einer Steuereinrichtung, und mit einer Messeinrichtung mit einem zumindest zwei Widerstände enthaltenden Spannungsteiler, einem Schalter zum Zuschalten eines Widerstands des Spannungsteilers und einer Spannungsmesseinheit zur Erfassung von Messspannungen an zumindest einem Widerstand des Spannungsteilers bei geöffnetem und geschlossenem Schalter des Spannungsteilers während einer Einprägung der Zwischenkreisspannung an den DC-Eingang und zur Bestimmung des Isolationswiderstands aus den erfassten Messspannungen.

Weiters betrifft die Erfindung einen Photovoltaik-Wechselrichter zur Bestimmung des Isolationswiderstands einer Photovoltaik-Anlage gegen Erde, mit zumindest einem DC-Eingang zur Verbindung mit zumindest einem Photovoltaik-Modul oder einem String mehrerer Photovoltaik-Module, einem DC/DC-Wandler mit einer Eingangsdiode, einem Zwischenkreis, einem DC/AC-Wandler, einem AC-Trenner, einem AC-Ausgang zur Verbindung mit einem Versorgungsnetz und bzw. oder Verbraucher, einer Steuereinrichtung, und mit einer Messeinrichtung mit einem zumindest zwei Widerstände enthaltenden Spannungsteiler, einem Schalter zum Zuschalten eines Widerstands des Spannungsteilers und einer Spannungsmesseinheit zur Erfassung von Messspannungen an zumindest einem Widerstand des Spannungsteilers bei geöffnetem und geschlossenem Schalter des Spannungsteilers während einer Einprägung der Zwischenkreisspannung an den DC-Eingang, und zur Bestimmung des Isolationswiderstands aus den erfassten Messspannungen.

Eine Photovoltaikanlage besitzt einen gewissen Isolationswiderstand gegen Erde, der sich aus den Isolationswiderständen der Photovoltaik-Module, der Kabel, des Photovoltaik-Wechselrichters und allfälliger daran angeschlossenen Energiespeicher gegen Erde zusammensetzt. Um zu verhindern, dass Fehlerströme über die Photovoltaik-Module oder andere Komponenten der Photovoltaik-Anlage fließen und um gefährliche Berührungsspannungen zu vermeiden, dürfen gewisse Grenzwerte des Isolationswiderstands nicht unterschritten werden. Deshalb muss der Isolationswiderstand vor der Verbindung mit dem Versorgungsnetz bei offenem AC-Trenner gemessen werden. Aufgrund verschiedener Vorschriften sind daher die Isolationswiderstände von Photovoltaik-Anlagen regelmäßig zu überprüfen, zumindest vor dem Zuschalten eines Photovoltaik-Wechselrichters an das Versorgungsnetz oder die Verbraucher bzw. zumindest einmal täglich. Typische Grenzwerte für den Isolationswiderstand von Photovoltaik-Anlagen liegen in Abhängigkeit des jeweiligen Landes bei 30 kOhm bis 1 MOhm.

Zum Zweck der Isolationswiderstandsmessung von Photovoltaik-Modulen werden diese bzw. der String mehrerer Photovoltaik-Module vom Photovoltaik-Wechselrichter getrennt und eine Messspannung angelegt und über den resultierenden Strom der Isolationswiderstand bestimmt. Abgesehen davon, dass derartige Messschaltungen sehr aufwändig sind, ist das Trennen der Photovoltaik-Module vom Wechselrichter nicht oder nicht einfach durchführbar.

Daher gibt es auch Verfahren und Photovoltaik-Wechselrichter, welche die Messung des Isolationswiderstands automatisch vor dem Zuschalten an das Versorgungsnetz vornehmen. Beispielsweise beschreibt die DE 10 2017 113 192 B3 ein Verfahren zur Bestimmung des Isolationswiderstands in einer Photovoltaik-Anlage, welche relativ aufwändig ist.

Moderne Photovoltaik-Anlagen, sogenannte Hybrid-Photovoltaik-Anlagen, weisen häufig Energiespeicher auf, über welche elektrische Energie zwischengespeichert werden kann, um diese auch zu Zeiten, während denen von den Photovoltaik-Modulen keine Spannung erzeugt wird, ins Versorgungsnetz einspeisen oder zur Versorgung der Verbraucher verwenden zu können. Somit ist ein Zuschalten des Photovoltaik-Wechselrichters an das Versorgungsnetz oder die Verbraucher auch während der Nachtstunden gewünscht oder notwendig. Vor dem Zuschalten bzw. Schließen des AC-Trenners ist jedoch eine Bestimmung des Isolationswiderstands vorgeschrieben oder zweckmäßig. Viele bekannte Verfahren ermöglichen jedoch nicht die Messung des Isolationswiderstands der Photovoltaik-Anlage während der Nacht, da die Photovoltaik-Module ohne Sonneneinstrahlung besonders hochohmig sind und mit herkömmlichen Methoden keine zuverlässige Messung des Isolationswiderstands in der Nacht durchführbar ist. Darüber hinaus bleiben solche an den Wechselrichter angeschlossene Energiespeicher bei der Überprüfung des Isolationswiderstands häufig unbeachtet, obgleich sie das Messergebnis beeinflussen können.

Moderne Photovoltaik-Module weisen eine integrierte Elektronik, sogenannte MLPE (Module-Level Power Electronics) auf, über welche die Leistung der Photovoltaik-Module optimiert werden kann. Derartige Schaltungen beinhalten meist auch Schalter, mit welchen einzelne Module deaktiviert werden können, beispielsweise wenn sie verschattet sind. Die Abschaltung ("Rapid Shutdown") der mit einer solchen Elektronik ausgestatteten Photovoltaik-Modulen kann beispielsweise aus Sicherheitsgründen vorgenommen werden müssen, um sicherzustellen, dass keine gefährlichen Gleichspannungen an den Zuleitungen zum Photovoltaik-Wechselrichter anliegen. In diesem Fall wäre eine genaue Messung des Isolationswiderstands mit herkömmlichen Messverfahren ebenfalls nicht möglich.

Die Aufgabe der vorliegenden Erfindung besteht darin, ein oben genanntes Verfahren und einen oben genannten Photovoltaik-Wechselrichter zur Bestimmung des Isolationswiderstands einer Photovoltaik-Anlage gegen Erde zu schaffen, wodurch eine einfache und rasche Bestimmung möglich ist, um bei Unterschreitung von Grenzwerten ein Zuschalten des Photovoltaik-Wechselrichters an das Versorgungsnetz und bzw. oder Verbraucher zu verhindern. Dabei soll der gesamte Isolationswiderstand der Photovoltaikanlage, also allfällige Isolationswiderstände zwischen den Photovoltaik-Modulen und Erde, aber auch zwischen allfälligen Energiespeichern und Erde, bestimmt und berücksichtigt werden. Nachteile bekannter Verfahren und Vorrichtungen sollen reduziert oder vermieden werden.

Die Aufgabe wird in verfahrensmäßiger Hinsicht dadurch gelöst, dass die Messspannungen bei geöffnetem AC-Trenner während der DC-Eingang mit einem Eingangskurzschlussschalter kurzgeschlossen wird, wodurch die Zwischenkreisspannung in umgekehrter Richtung an den DC-Eingang angelegt wird, erfasst werden, dass jeweils eine Messspannung bei geöffnetem und geschlossenem Schalter des Spannungsteilers erfasst wird, und aus den Messwerten der beiden erfassten Messspannungen bei geöffnetem und geschlossenen Schalter des Spannungsteilers der Isolationswiderstands bestimmt wird. Durch das Kurzschließen des DC-Eingangs des Photovoltaik-Wechselrichters wird ein Stromkreis gebildet, bei dem die Photovoltaik-Module in Richtung der parallel zu den Photovoltaik-Modulen geschalteten Bypass-Dioden mit Strom vom Zwischenkreis durchflossen werden. Dadurch ist insbesondere auch während der Nachtstunden, wenn die Photovoltaik-Module besonders hochohmig sind, oder die Photovoltaik-Module aus anderen Gründen keine Spannung erzeugen, eine genaue Messung des Isolationswiderstands möglich. Mit Hilfe der Spannungsmesseinheit werden die Messspannungen bei geöffnetem und geschlossenem Schalter erfasst und daraus der Isolationswiderstand bestimmt. Dies erfolgt über die Werte der beiden Messspannungen unter Kenntnis der Werte der Widerstände des Spannungsteilers. Die für die Messung erforderliche Spannung wird in Form der Zwischenkreisspannung vom Zwischenkreis des Photovoltaik-Wechselrichters zur Verfügung gestellt. Der Zwischenkreis wird entweder von einem Netzteil, dem DC-Eingang oder einem Energiespeicher mit elektrischer Energie versorgt. Das Verfahren eignet sich auch bei Photovoltaik-Modulen mit integrierter Elektronik, sogenannten MLPE (Module-Level Power Electronics), bei welchen eine zuverlässige Messung des Isolationswiderstands bisher nicht möglich war. Der AC-Trenner ist während der Bestimmung des Isolationswiderstands geöffnet, der Photovoltaik-Wechselrichter also vollständig vom Versorgungsnetz bzw. von Verbrauchern getrennt. Natürlich kann der Isolationswiderstand auch tagsüber, wenn die Photovoltaik-Module eine Spannung liefern, nach diesem Verfahren gemessen werden. Allerdings wird in diesem Fall der Eingangskurzschlussschalter durch den höheren Strom mehr belastet, weshalb der Isolationswiderstand auch mit herkömmlichen Verfahren bestimmt werden kann. Einfehlersicherheit ist bei der Bestimmung des Isolationswiderstands gegeben, da bereits der Fehler einer Komponente der für die Messung relevanten Komponenten (Eingangskurzschlussschalters, Widerstände des Spannungsteilers, Schalter zum Zuschalten eines Widerstands des Spannungsteilers) keine Messung und damit auch keine Fehlmessung möglich ist.

Gemäß einem weiteren Merkmal wird der AC-Trenner des Photovoltaik-Wechselrichters nur dann geschlossen, wenn ein definierter minimaler Isolationswiderstand überschritten wird. Dadurch kann eine Gefährdung aufgrund unzulässig hoher Fehlerströme und eine Beschädigung von Komponenten der Photovoltaik-Anlage verhindert werden.

Soll der absolute Isolationswiderstand bestimmt und nicht nur die Überschreitung eines definierten minimalen Isolationswiderstands festgestellt werden, werden die Messspannungen während einer vorgegebenen Zeitspanne, insbesondere 1 s bis 10 s, erfasst. Die Messung der absoluten Werte für den Isolationswiderstand erfordern ein Abwarten des Abklingens diverser Einschwingvorgänge innerhalb der vorgegebenen Zeitspanne. Bei üblichen Leistungsklassen von Photovoltaik-Anlagen im Bereich einiger kW haben sich Zeitspannen im Bereich zwischen 1 s und 10 s als geeignet erwiesen. Dementsprechend dauert die Messung des absoluten Isolationswiderstands länger als die Messung des relativen Isolationswiderstands. Danach kann der Photovoltaik-Wechselrichter an das Versorgungsnetz und bzw. oder Verbraucher zugeschaltet werden.

Wenn der DC-Eingang über einen vorhandenen Boost-Schalter des als Booster ausgebildeten DC/DC-Wandlers des Photovoltaik-Wechselrichters als Eingangskurzschlussschalters kurzgeschlossen wird, kann der vorhandene Boost-Schalter zu den Zwecken der genauen und zuverlässigen Bestimmung des Isolationswiderstands verwendet werden, ohne dass eine eigene Hardware erforderlich ist.

Gemäß einem weiteren Merkmal der Erfindung kann die Spannung am DC-Eingang des Photovoltaik-Wechselrichters gemessen, und bei Unterschreitung eines voreingestellten Grenzwerts der Spannung der DC-Eingang mit dem Eingangskurzschlussschalter kurzgeschlossen werden. Dadurch wird gewährleistet, dass während der Nachtstunden oder wenn die Photovoltaik-Module aus anderen Gründen, wie zum Beispiel der Aktivierung einer in den Photovoltaik-Modulen integrierten Elektronik, keine bzw. eine zu geringe Spannung liefern, eine genaue Bestimmung der Messwerte und somit Bestimmung des Isolationswiderstands möglich wird, indem die Zwischenkreisspannung in umgekehrter Richtung an die Photovoltaik-Module angelegt wird.

Vorzugsweise wird zusätzlich zum Isolationswiderstand auch die Anlagenkapazität über den zeitlichen Verlauf der Messspannung nach dem Schließen des Schalters des Spannungsteilers bestimmt. Eine Photovoltaikanlage besitzt üblicherweise eine gewisse Anlagenkapazität gegen Erde. Üblicherweise ist die Anlagenkapazität relativ klein, wodurch nur relativ geringe kapazitive Ableitströme resultieren. Eine Reihe von Faktoren, insbesondere feuchtes Wetter bzw. Wasser, beeinflussen neben der Montageart der Photovoltaik-Module und möglichen Isolationsfehlern von Komponenten der Photovoltaik-Anlage die Anlagenkapazität. Steigt die Anlagenkapazität, so steigen auch die kapazitiven Ableitströme. Im Falle des Zuschaltens des Photovoltaik-Wechselrichters an das Versorgungsnetz und bzw. oder Verbraucher kann es im Falle höherer Anlagenkapazitäten aufgrund höherer kapazitiver Ableitströme zu einem Auslösen der Anlagensicherungen kommen. Beispielsweise sehen verschiedene Länder Fehlerstrom-Schutzschalter (FI-Schutzschalter) vor, welche zur Absicherung der Photovoltaik-Anlagen schon bei beispielsweise 30 mA auslösen. Nach einer Auslösung des FI-Schutzschalters muss dieser wieder manuell eingeschaltet werden. Bis dies geschieht, kann unter Umständen viel Zeit vergehen, während welcher keine Einspeisung elektrischer Energie in das Versorgungsnetz oder keine Versorgung von Verbrauchern mit elektrischer Energie stattfindet. Dementsprechend sinkt der Ertrag der Photovoltaik-Anlage und ein möglicher Gewinn für den Benutzer der Photovoltaik-Anlage. Mit Hilfe der Spannungsmesseinheit werden die Messspannungen bei geöffnetem und geschlossenem Schalter erfasst und aus dem zeitlichen Verlauf der Messspannung nach dem Schließen des Schalters des Spannungsteilers die Anlagenkapazität bestimmt. Dies erfolgt über die Zeitkonstante des zeitlichen Verlaufs der Messspannung unter Kenntnis der Werte der Widerstände des Spannungsteilers. Das Verfahren eignet sich auch bei Photovoltaik-Modulen mit integrierter Elektronik, sogenannten MLPE (Module-Level Power Electronics), bei welchen eine zuverlässige Messung der Anlagenkapazität bisher nicht möglich war. Der AC-Trenner ist während der Bestimmung der Anlagenkapazität geöffnet, der Photovoltaik-Wechselrichter also vollständig vom Versorgungsnetz bzw. von Verbrauchern getrennt. Natürlich kann die Anlagenkapazität auch tagsüber, wenn die Photovoltaik-Module eine Spannung liefern, nach diesem Verfahren gemessen werden. Allerdings wird in diesem Fall der Eingangskurzschlussschalter durch den höheren Strom mehr belastet, weshalb die Anlagenkapazität auch mit herkömmlichen Verfahren bestimmt werden kann. Einfehlersicherheit ist bei der Bestimmung der Anlagenkapazität, da bereits der Fehler einer Komponente der für die Messung relevanten Komponenten (Eingangskurzschlussschalters, Widerstände des Spannungsteilers, Schalter zum Zuschalten eines Widerstands des Spannungsteilers) keine Messung und damit auch keine Fehlmessung möglich ist.

Vorzugsweise wird der AC-Trenner des Photovoltaik-Wechselrichters nur dann geschlossen, wenn eine definierte maximale Anlagenkapazität unterschritten wird. Dadurch kann ein ungewolltes Auslösen eines Fehlerstrom-Schutzschalters im Falle einer unzulässig hohen Anlagenkapazität der Photovoltaik-Anlage verhindert werden und es können Zeiten, während der keine Energieerzeugung durch die Photovoltaik-Anlage stattfindet, reduziert werden.

Wenn, wie bei sogenannten Hybrid-Wechselrichtern, ein Energiespeicher vorgesehen ist, kann dieser Energiespeicher durch Schließen eines Batterietrenners zugeschaltet werden, und die Messspannungen erfasst und daraus der Isolationswiderstand und allenfalls die Anlagenkapazität bestimmt werden. Dadurch, dass sichergestellt wird, dass der Energiespeicher während der Bestimmung des Isolationswiderstands und allenfalls der Anlagenkapazität zugeschaltet ist, kann auch der Beitrag des Energiespeichers zum Isolationswiderstand und allenfalls zur gesamten Anlagenkapazität sicher erfasst werden .

Dabei kann die Überschreitung des definierten minimalen Isolationswiderstands, der absolute Isolationswiderstand, allenfalls die Unterschreitung der definierten maximalen Anlagenkapazität und bzw. oder allenfalls die absolute Anlagenkapazität jeweils mit und ohne zugeschaltetem Energiespeicher bestimmt werden. Idealerweise erfolgt die Messung des Isolationswiderstands und allenfalls der Anlagenkapazität sowohl bei zugeschaltetem Energiespeicher als auch bei getrenntem Energiespeicher. Dadurch kann auch der Beitrag des Energiespeichers zum Isolationswiderstand und zur Anlagenkapazität gesondert erfasst werden und ein Fehler in der Photovoltaik-Anlage auch besser eingegrenzt bzw. schneller aufgefunden werden.

Vorzugsweise wird die Überschreitung des definierten minimalen Isolationswiderstands, der absolute Isolationswiderstand allenfalls die Unterschreitung der definierten maximalen Anlagenkapazität und bzw. oder allenfalls die absolute Anlagenkapazität während der Nachtstunden ermittelt. Wie bereits weiter oben erwähnt, kann es bei modernen Hybrid-Wechselrichtern auch während der Nachtstunden sinnvoll oder notwendig sein, diese an das Versorgungsnetz bzw. die Verbraucher zuzuschalten, um beispielsweise Energie vom Energiespeicher in das Versorgungsnetz einspeisen zu können.

Entsprechend einschlägigen Vorschriften wird zumindest die Überschreitung des definierten minimalen Isolationswiderstands, und bzw. oder der absolute Isolationswiderstand, allenfalls die Unterschreitung der definierten maximalen Anlagenkapazität und bzw. oder allenfalls die absolute Anlagenkapazität zumindest einmal täglich ermittelt, insbesondere vor jedem Zuschalten des Photovoltaik-Wechselrichters an das Versorgungsnetz und bzw. oder Verbraucher durch Schließen des AC-Trenners.

Vorteilhafterweise werden die Messspannungen über eine definierte Zeitspanne gemittelt. Beispielsweise erfolgt die Abtastung der Messwerte mit einer Abtastfrequenz von 10 kHz und blockweise die Bildung eines arithmetischen Mittelwerts aus 10 Messwerten. Durch eine Mittelwertbildung resultiert eine Glättung der Messwerte und ergeben sich somit zuverlässigere Messwerte.

Das Überschreiten des definierten minimalen Isolationswiderstands, der absolute Isolationswiderstand, allenfalls das Unterschreiten der definierten maximalen Anlagenkapazität, und bzw. oder allenfalls die absolute Anlagenkapazität kann angezeigt und bzw. oder gespeichert werden. Das Anzeigen und bzw. oder Speichern der Messwerte kann zu Dokumentationszwecken oder zur Überwachung dienen. Natürlich können die Werte bei Bedarf auch aus der Ferne abgefragt werden, wie es bei anderen Messdaten moderner Photovoltaik-Anlagen üblich ist.

Vorteilhafterweise wird das Überschreiten des definierten minimalen Isolationswiderstands, der absolute Isolationswiderstand, allenfalls das Unterschreiten der definierten maximalen Anlagenkapazität, und bzw. oder allenfalls die absolute Anlagenkapazität innerhalb einer Messzeit von maximal 10 s bestimmt. Bei Photovoltaik-Anlagen in üblichen Leistungsbereichen von einigen kW haben sich derartig kurze Messzeiten als möglich erwiesen. Durch solche kurzen Messzeiten muss trotz häufiger Messungen des Isolationswiderstandes und allenfalls der Anlagenkapazität kaum auf wertvolle Zeit zum Einspeisen von Energie in das Versorgungsnetz und bzw. oder das Versorgen von Verbrauchern mit elektrischer Energie verzichtet werden. Dadurch zeichnen sich solche Photovoltaik-Anlagen durch besonders hohen Ertrag aus.

Gelöst wird die erfindungsgemäße Aufgabe auch durch einen oben genannten Photovoltaik-Wechselrichter, wobei die Messeinrichtung zur Betätigung eines Eingangskurzschlussschalters zum Kurzschließen des DC-Eingangs bei geöffnetem AC-Trenner ausgebildet ist, wodurch die Zwischenkreisspannung in umgekehrter Richtung an den DC-Eingang anlegbar ist, und die Messeinrichtung zur Erfassung jeweils einer Messspannung bei geöffnetem und geschlossenem Schalter des Spannungsteilers und der einfehlersicheren Ermittlung des Isolationswiderstands aus den Messwerten der beiden erfassten Messspannungen bei geöffnetem und geschlossenem Schalter des Spannungsteilers eingerichtet ist. Der Photovoltaik-Wechselrichter ermöglicht die genaue Bestimmung des Isolationswiderstands bei vollständig geöffnetem AC-Trenner, insbesondere auch während der Nachtstunden, wenn die Photovoltaik-Module keine Spannung liefern oder eine Elektronik der Photovoltaik-Module aktiviert ist und die Berücksichtigung allfälliger Energiespeicher, welche an den Photovoltaik-Wechselrichter angeschlossen sind. Der Hardware-Aufwand ist besonders gering, die notwendige Programmierung des Messverfahrens kann auch in einer ohnedies vorhandenen Steuereinrichtung des Photovoltaik-Wechselrichters erfolgen. Der Schalter des Spannungsteilers kann aufgrund des geringen Stromes durch sehr kleine und kostengünstige Relais gebildet werden. Zu den weiteren mit dem erfindungsgemäßen Photovoltaik-Wechselrichter erzielbaren Vorteilen wird auf die obige Beschreibung des Verfahrens zur Bestimmung des Isolationswiderstands der Photovoltaik-Anlage gegen Erde verwiesen.

Die Messeinrichtung ist vorzugsweise mit dem AC-Trenner oder der Steuereinrichtung verbunden, sodass der AC-Trenner nur bei Überschreitung eines definierten minimalen Isolationswiderstands schließbar ist. Dadurch wird gewährleistet, dass während der Nachtstunden oder wenn die Photovoltaik-Module aus anderen Gründen, wie zum Beispiel der Aktivierung einer in den Photovoltaik-Modulen integrierten Elektronik, keine bzw. eine zu geringe Spannung liefern, eine genaue Bestimmung der Messwerte möglich wird, indem die Zwischenkreisspannung in umgekehrter Richtung an die Photovoltaik-Module angelegt wird.

Vorteilhafterweise ist die Messeinrichtung zur Messung des absoluten Isolationswiderstands ausgebildet, indem die Messspannungen bei geöffnetem und geschlossenem Schalter des Spannungsteilers während einer vorgegebenen Zeitspanne, insbesondere von 1 s bis 10 s, erfassbar sind. Die Messung der absoluten Werte für den Isolationswiderstand erfordern ein Abwarten diverser Einschwingvorgänge, weshalb die Messungen während der vorgegebenen Zeitspanne erfolgen. Dementsprechend länger dauert die Messung natürlich, bevor eine Zuschaltung des Photovoltaik-Wechselrichters an das Versorgungsnetz oder die Verbraucher durchgeführt werden kann.

Gemäß einem weiteren Merkmal der Erfindung ist zumindest ein mit dem Zwischenkreis verbundener Batterieanschluss mit zumindest einem Batterietrenner zur Verbindung mit zumindest einem Energiespeicher vorgesehen, wobei der Batterietrenner mit der Messeinrichtung oder der Steuereinrichtung verbunden ist, sodass der Batterietrenner während der Erfassung der Messspannungen betätigbar ist. Dadurch kann sichergestellt werden, dass ein allfälliger Erdschluss des Energiespeichers bei der Messung des Isolationswiderstands und allenfalls der Anlagenkapazität berücksichtigt wird.

Wenn der Eingangskurzschlussschalter durch einen vorhandenen Boost-Schalter des als Booster ausgebildeten DC/DC-Wandlers gebildet ist, kann der Hardwareaufwand reduziert werden.

Die Messeinrichtung kann zur Messung der Eingangsspannung am DC-Eingang des Photovoltaik-Wechselrichters ausgebildet sein, sodass bei einer Unterschreitung eines vorgegebenen Grenzwerts der gemessenen Eingangsspannung der Eingangskurzschlussschalter schließbar ist. Dadurch wird sichergestellt, dass die Zwischenkreisspannung in umgekehrter Richtung an die Photovoltaik-Module bzw. den String an Photovoltaik-Modulen angelegt wird, wodurch eine genaue Messung des Isolationswiderstands und allenfalls der Anlagenkapazität auch in den Nachtstunden oder wenn das Photovoltaik-Modul aus anderen Gründen keine oder eine zu geringe Spannung liefert, gewährleistet wird.

Vorteilhafterweise ist die Messeinrichtung auch zur Messung der Anlagenkapazität und zum Vergleich der Anlagenkapazität mit einer definierten maximalen Anlagenkapazität ausgebildet, sodass der AC-Trenner nur bei Unterschreitung der definierten maximalen Anlagenkapazität schließbar ist.

Insbesondere ist die Messeinrichtung zur Ermittlung des Isolationswiderstands und allenfalls der Anlagenkapazität beim Anschluss von Photovoltaik-Modulen mit integrierter Elektronik (sogenannte MLPE Module-Level Power Electronics) am DC-Eingang ausgebildet. Damit kann beispielsweise eine zuverlässige Bestimmung des Isolationswiderstands und allenfalls der Anlagenkapazität auch bei Photovoltaik-Modulen mit aktiviertem "Rapid Shutdown" vorgenommen werden. Die Abschaltung der mit einer solchen Elektronik ausgestatteten Photovoltaik-Modulen kann beispielsweise aus Sicherheitsgründen vorgenommen werden müssen, um sicherzustellen, dass keine gefährlichen Gleichspannungen an den Zuleitungen zum Photovoltaik-Wechselrichter anliegen.

Vorteilhafterweise ist eine Anzeige zum Anzeigen und bzw. oder ein Speicher zum Speichern des Überschreitens des definierten minimalen Isolationswiderstands, des absoluten Isolationswiderstands, allenfalls des Unterschreitens der definierten maximalen Anlagenkapazität, und bzw. oder der absoluten Anlagenkapazität vorgesehen.

Die vorliegende Erfindung wird anhand der beigefügten Zeichnungen näher erläutert. Darin zeigen:
- Fig. 1: ein Blockschaltbild eines erfindungsgemäß ausgebildeten Photovoltaik-Wechselrichters zur Bestimmung des Isolationswiderstands gegen Erde;
- Fig. 2: ein vereinfachtes Schaltbild eines erfindungsgemäß ausgebildeten Photovoltaik-Wechselrichters mit daran angeschlossenen Photovoltaik-Modulen;
- Fig. 3: ein vereinfachtes Schaltbild eines erfindungsgemäß ausgebildeten Photovoltaik-Wechselrichters mit daran angeschlossenen Photovoltaik-Modulen mit integrierter Elektronik
- Fig. 4: ein vereinfachtes Schaltbild eines erfindungsgemäß ausgebildeten Photovoltaik-Wechselrichters mit daran angeschlossenen Photovoltaik-Modulen mit integrierter Elektronik und einem daran angeschlossenen Energiespeicher;
- Fig. 5: ein Flussdiagramm zur Veranschaulichung der Bestimmung der relativen Anlagenkapazität und des relativen Isolationswiderstands;
- Fig. 6: ein Flussdiagramm zur Veranschaulichung der Bestimmung der relativen Anlagenkapazität und des relativen Isolationswiderstands bei einem Hybrid-Wechselrichter mit angeschlossenem Energiespeicher;
- Fig. 7: ein Flussdiagramm zur Veranschaulichung der Bestimmung der absoluten Anlagenkapazität und des absoluten Isolationswiderstands; und
- Fig. 8: ein Flussdiagramm zur Veranschaulichung der Bestimmung der absoluten Anlagenkapazität und des absoluten Isolationswiderstands bei einem Hybrid-Wechselrichter mit angeschlossenem Energiespeicher.

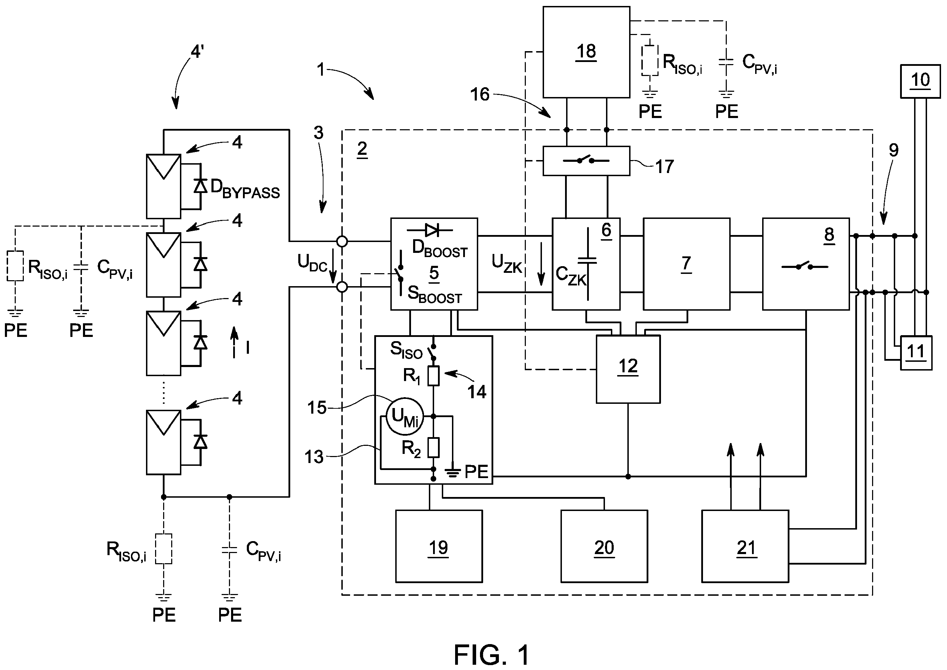

In Fig. 1 ist ein Blockschaltbild eines erfindungsgemäß ausgebildeten Transformator-losen Photovoltaik-Wechselrichters 2 einer Photovoltaik-Anlage 1 zur Bestimmung des Isolationswiderstands Rᵢₛₒ gegen Erde PE dargestellt. Der Photovoltaik-Wechselrichter 2 beinhaltet zumindest einen DC-Eingang 3 zur Verbindung mit zumindest einem Photovoltaik-Modul 4 oder einem String 4' mehrerer Photovoltaik-Module 4. Die Photovoltaik-Module 4 weisen eine Bypass-Diode D_{Bypass} auf, um im Falle der Verschattung eines Photovoltaik-Moduls 4 eines Strings 4' einen Stromfluss zu ermöglichen. Nach dem DC-Eingang 3 des Photovoltaik-Wechselrichters 2 ist ein DC/DC-Wandler 5 angeordnet, der häufig als Booster oder Aufwärtswandler bzw. Hochsetzsteller ausgebildet ist. Im DC/DC-Wandler 5 ist eine Eingangsdiode (auch Boost-Diode) D_{boost} angeordnet. Danach sind der Zwischenkreis 6, ein DC/AC-Wandler 7, ein AC-Trenner 8 und ein AC-Ausgang 9 zur Verbindung mit einem Versorgungsnetz 10 und bzw. oder Verbrauchern 11 vorgesehen. Über eine Steuereinrichtung 12 werden die verschiedenen Komponenten des Photovoltaik-Wechselrichters 2 gesteuert bzw. geregelt. Um auch bei Nacht, während der die Photovoltaik-Module 4 keine Spannung liefern, unabhängig vom Versorgungsnetz 10 sein zu können, sind am Photovoltaik-Wechselrichter 2 häufig über einen Batterieanschluss 16 entsprechende Energiespeicher 18 angeschlossen. Die Energiespeicher 18 werden über einen Batterietrenner 17 mit dem Photovoltaik-Wechselrichter 2 verbunden, um diese auch vom Photovoltaik-Wechselrichter 2 trennen zu können. Der Batterietrenner 17, der auch im Energiespeicher 18 integriert sein kann, sowie der Energiespeicher 18 sind üblicherweise mit der Steuereinrichtung 12 verbunden, was durch die strichlierte Linie dargestellt ist. Ein Netzteil 21 versorgt die Komponenten des Photovoltaik-Wechselrichters 2 mit elektrischer Energie.

Die Photovoltaik-Anlage 1 besitzt eine gewisse Anlagenkapazität C_{PV} gegen Erde PE, welche sich aus einzelnen Kapazitäten C_{PV,i} gegen Erde PE zusammensetzt. Im Ersatzschaltbild kann die gesamte Anlagenkapazität C_{PV} aus einer Parallelschaltung verschiedener Anlagenkapazitäten C_{PV,i} dargestellt werden. Beispielsweise existieren zwischen den Photovoltaik-Modulen 4 und Erde PE bestimmte Kapazitäten C_{PV,i} wie auch zwischen allfälligen Energiespeichern 18 und Erde PE, welche sich zur gesamten Anlagenkapazität C_{PV} summieren. Um zu verhindern, dass bei einem unzulässig hohen Wert der Anlagenkapazität C_{PV} beim Zuschalten des Photovoltaik-Wechselrichters 2 an das Versorgungsnetz 10 oder die Verbraucher 11 der Fehlerstrom-Schutzschalter (nicht dargestellt), der zur Absicherung der Photovoltaik-Anlage 1 vorgesehen ist, ausgelöst wird, ist eine regelmäßige Bestimmung der Anlagenkapazität C_{PV} der gesamten Photovoltaik-Anlage 1 wichtig. Dabei kann eine Messung der relativen Anlagenkapazität C_{PV}, also die Unterschreitung der definierten maximalen Anlagenkapazität C_{PV_max} ausreichen oder die absolute Anlagenkapazität C_{PV} bestimmt werden.

Die Photovoltaik-Anlage 1 besitzt auch einen gewissen Isolationswiderstand Rᵢₛₒ gegen Erde PE, welcher sich ebenfalls aus einzelnen Teilisolationswiderständen R_{iso,i} gegen Erde PE zusammensetzt. Im Ersatzschaltbild kann der gesamte Isolationswiderstand Rᵢₛₒ aus einer Parallelschaltung verschiedener Teilisolationswiderstände R_{iso,i} dargestellt werden. Beispielsweise existieren zwischen den Photovoltaik-Modulen 4 und Erde PE bestimmte Teilisolationswiderstände R_{iso,i} wie auch zwischen allfälligen Energiespeichern 18 und Erde PE, welche den gesamten Isolationswiderstand Rᵢₛₒ bilden. Um eine Gefährdung von Personen aber auch eine Zerstörung von Komponenten der Photovoltaik-Anlage 1 verhindern zu können, ist eine regelmäßige Bestimmung des tatsächlichen Isolationswiderstands Rᵢₛₒ der gesamten Photovoltaik-Anlage 1 wichtig oder meist sogar vorgeschrieben. Dabei kann eine Messung des relativen Isolationswiderstands Rᵢₛₒ, also die Überschreitung eines definierten minimalen Isolationswiderstands R_{iso_min} oder der absolute Isolationswiderstand Rᵢₛₒ bestimmt werden.

Meist werden sowohl die Anlagenkapazität C_{PV} als auch der Isolationswiderstand Rᵢₛₒ gleichzeitig bzw. unmittelbar hintereinander bestimmt.

Zu diesem Zweck ist eine Messeinrichtung 13 vorgesehen, welche einen zumindest zwei Widerstände R₁, R₂ enthaltenden Spannungsteiler 14 und einen Schalter Sᵢₛₒ zum Zuschalten eines Widerstands R₁ des Spannungsteilers 14 beinhaltet. Über eine Spannungsmesseinheit 15 werden an zumindest einem Widerstand R₂ des Spannungsteilers 14 Messspannungen U_{Mi} erfasst. Bei geöffnetem Schalter Sᵢₛₒ wird ein erster Messwert der Messspannung U_{M1} ermittelt und bei geschlossenem Schalter Sᵢₛₒ ein zweiter Messwert der Messspannung U_{M2}. Aus dem zeitlichen Verlauf der Messspannung U_{M2} nach dem Schließen des Schalters Sᵢₛₒ kann die Anlagenkapazität C_{PV} bestimmt werden. Dies erfolgt über die Zeitkonstante des zeitlichen Verlaufs der Messspannung U_{M2} und Kenntnis der Widerstände R₁, R₂ des Spannungsteilers 14. Der Isolationswiderstand Rᵢₛₒ wird ebenfalls aus den beiden Messwerten U_{M1}, U_{M2} und Kenntnis der Widerstände R₁, R₂ des Spannungsteilers 14 bestimmt. Die für die Messung erforderliche Spannung wird in Form der Zwischenkreisspannung U_{ZK} vom Zwischenkreis 6 zur Verfügung gestellt. Die dafür notwendige elektrische Energie wird von einem Netzteil 21, dem DC-Eingang 3 oder einem Energiespeicher 18 zur Verfügung gestellt.

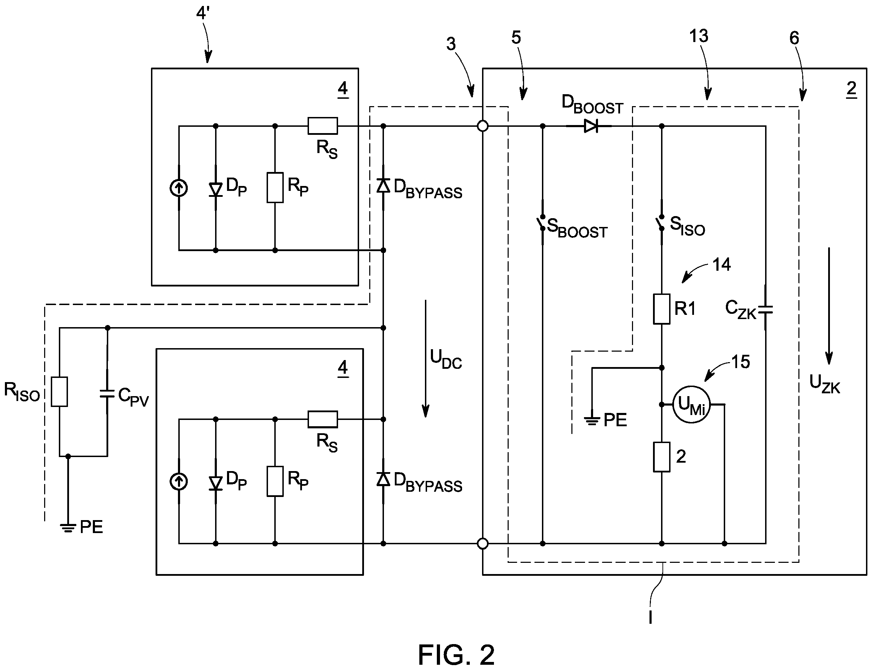

Bisher war eine Messung der Anlagenkapazität C_{PV} und des Isolationswiderstands Rᵢₛₒ bei Tagesanbruch, wenn die Photovoltaik-Module 4 beginnen, eine Spannung zu erzeugen, vorgesehen. Eine Messung auch in den Nachtstunden ist in der Regel nicht notwendig oder nicht möglich gewesen. Wenn die Photovoltaik-Module 4 keine Spannung erzeugen, sind sie sehr hochohmig, weshalb eine genaue Messung des Isolationswiderstands Rᵢₛₒ nicht möglich wäre (siehe Fig. 2). Moderne Photovoltaik-Anlagen 1, insbesondere sogenannte Hybrid-Anlagen mit Energiespeichern 18 machen eine Messung der Anlagenkapazität C_{PV} und des Isolationswiderstands Rᵢₛₒ auch während der Nachtstunden notwendig und sinnvoll.

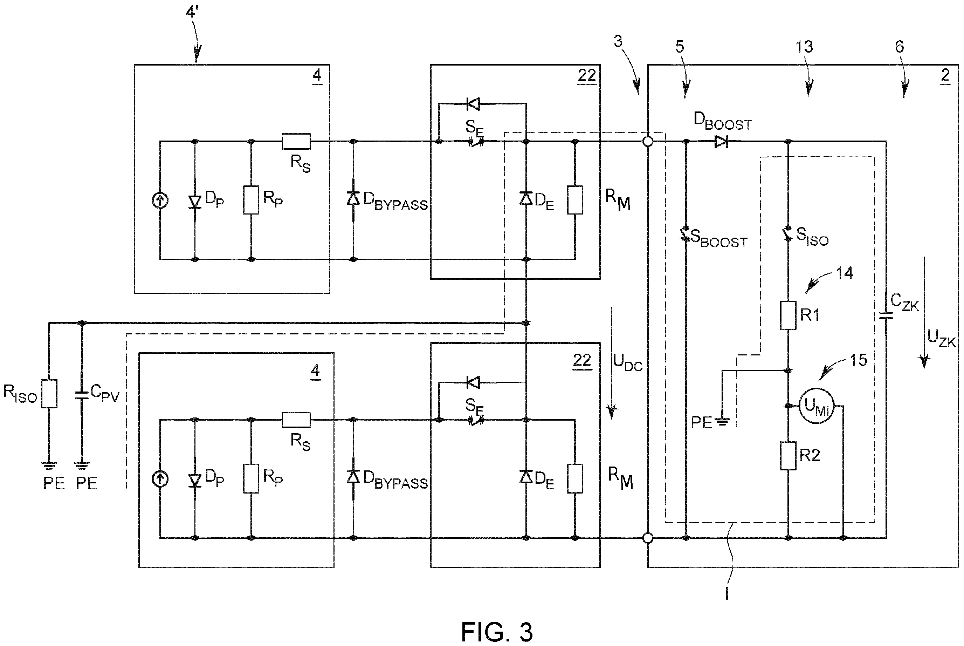

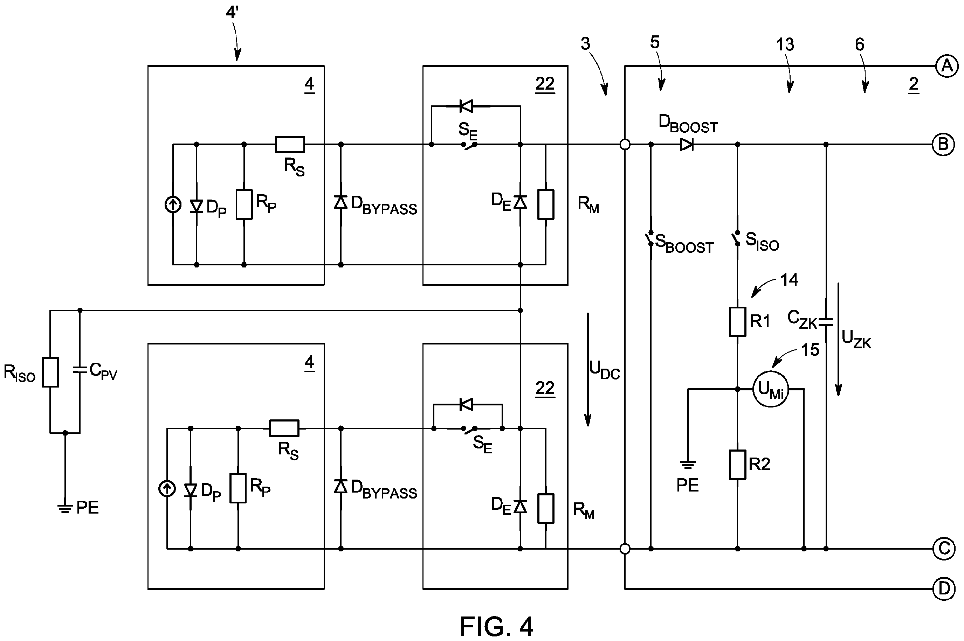

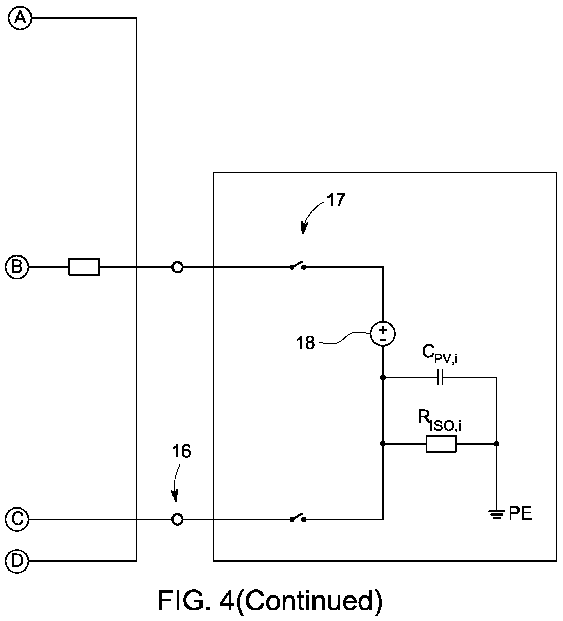

Erfindungsgemäß ist die Messeinrichtung 13 zur Betätigung eines Eingangskurzschlussschalters S_{Boost} zum Kurzschließen des DC-Eingangs 3 bei geöffnetem AC-Trenner 8 ausgebildet, wodurch die Zwischenkreisspannung U_{ZK} in umgekehrter Richtung an den DC-Eingang 3 anlegbar ist. Der Stromkreis wird also zwischen dem Zwischenkreis 6 und den Photovoltaik-Modulen 4 so geschlossen, dass der Strom I (strichlierter Pfeil) in Durchlassrichtung der Bypass-Dioden D_{Bypass} der Photovoltaik-Module 4 fließt. Dadurch kann auch in den Nachtstunden, wenn die Photovoltaik-Module 4 besonders hochohmig sind, eine zuverlässige Messung der Anlagenkapazität C_{PV} und des Isolationswiderstands Rᵢₛₒ erfolgen. Mit Hilfe der Spannungsmesseinheit 15 wird jeweils eine Messspannung U_{M1}, U_{M2} bei geöffnetem und geschlossenem Schalter Sᵢₛₒ erfasst und daraus die Anlagenkapazität C_{PV} und der Isolationswiderstand Rᵢₛₒ bestimmt. Der Eingangskurzschlussschalter S_{Boost} kann idealerweise durch einen als Booster ausgebildeten DC/DC-Wandler 5 angeordneten Boost-Schalter S_{Boost} gebildet sein, wodurch keine eigene Hardware erforderlich ist. Die Schaltung bzw. das Verfahren eignet sich auch bei Photovoltaik-Modulen 4 mit integrierter Elektronik 22 (siehe Fig. 3 und 4), sogenannten MLPE (Module-Level Power Electronic), bei welchen eine zuverlässige Messung der Anlagenkapazität C_{PV} oder des Isolationswiderstands Rᵢₛₒ bei bestimmten Schaltungen der Elektronik 22 bisher nicht möglich war. Darüber hinaus kann die Anlagenkapazität C_{PV} oder der Isolationswiderstands Rᵢₛₒ besonders genau und unter Berücksichtigung allenfalls angeschlossener Energiespeicher 18 erfolgen. Dabei muss nur sichergestellt werden, dass während der Messung der Messspannungen U_{M1}, U_{M2} der Energiespeicher 18 durch Schließen des Batterietrenners 17 zugeschaltet ist, sodass auch ein Erdschluss des Energiespeichers 18 entsprechend berücksichtigt wird. Idealerweise erfolgt die Messung der Anlagenkapazität C_{PV} und des Isolationswiderstands Rᵢₛₒ sowohl bei zugeschaltetem Energiespeicher 18 als auch bei getrenntem Energiespeicher 18. Dadurch kann auch der Beitrag des Energiespeichers 18 zur Anlagenkapazität C_{PV} und zum Isolationswiderstand Rᵢₛₒ gesondert erfasst werden und ein Fehler in der Photovoltaik-Anlage 1 auch besser eingegrenzt bzw. schneller aufgefunden werden.

Gegebenenfalls kann die Messeinrichtung 13 zur Messung der Spannung U_{DC} am DC-Eingang 3 ausgebildet sein und bei einer Unterschreitung eines vorgegebenen Grenzwerts U_{DC_limit} der gemessenenen Spannung U_{DC} der Eingangskurzschlussschalter S_{Boost} bei der Bestimmung der Anlagenkapazität C_{PV} und allenfalls des Isolationswiderstands Rᵢₛₒ betätigt bzw. geschlossen werden. Dadurch wird gewährleistet, dass während der Nachtstunden, wenn keine bzw. eine zu geringe Spannung U_{DC} von den Photovoltaik-Modulen 4 geliefert wird, eine genaue Bestimmung der Messwerte möglich wird.

Der Vollständigkeit halber sei erwähnt, dass ein Photovoltaik-Wechselrichter 2 auch mehrere DC-Eingänge 3 für den Anschluss mehrerer Strings 4' an Photovoltaik-Modulen 4 aufweisen kann. Dabei kann das beschriebene Verfahren zur Bestimmung der Anlagenkapazität C_{PV} und des Isolationswiderstands Rᵢₛₒ bei jedem DC-Eingang 3 durchgeführt werden. Die Zuschaltung an das Versorgungsnetz 10 bzw. den Verbrauchern 11 erfolgt dann nur bei jenen Strings 4' an Photovoltaik-Modulen 4, deren Anlagenkapazität C_{PV} unterhalb der definierten maximalen Anlagenkapazität C_{PV_max} liegt, oder der AC-Trenner 8 des Photovoltaik-Wechselrichter 2 wird nur dann geschlossen, wenn die Bedingung für alle Photovoltaik-Module 4 und alle Komponenten der Photovoltaik-Anlage 1 gilt.

Fig. 2 zeigt ein vereinfachtes Schaltbild eines erfindungsgemäß ausgebildeten Photovoltaik-Wechselrichters 2 mit daran angeschlossenen Photovoltaik-Modulen 4, wobei symbolisch die Anlagenkapazität C_{PV} und parallel dazu der Isolationswiderstand Rᵢₛₒ gegen Erde PE eingezeichnet ist. Die Photovoltaik-Module 4 sind im Ersatzschaltbild jeweils als Stromquellen mit paralleler parasitärer Diode D_{P} in Flussrichtung, Parallelwiderstand R_{P} und Serienwiderstand R_{S} dargestellt. Wenn die Zelle des Photovoltaik-Moduls 4 Strom liefert und eine Spannung U_{DC} am DC-Eingang 3 anliegt und die Durchflussspannung der parasitären Diode D_{P} unterschritten wird, wirkt sich nur der relativ geringe Serienwiderstand R_{S} (üblicherweise im mOhm-Bereich) aus. Während der Nachtstunden liefert die Zelle des Photovoltaik-Moduls 4 jedoch keinen Strom, weshalb der relativ hohe Parallelwiderstand R_{P} (üblicherweise einige kOhm) zur Geltung kommt. Bei herkömmlichen Messverfahren würde dieser hohe Parallelwiderstand R_{P} die Bestimmung der Anlagenkapazität C_{PV} und des Isolationswiderstands Rᵢₛₒ verfälschen bzw. unmöglich machen.

Die Photovoltaik-Module 4 sind jeweils durch eine Bypass-Diode D_{Bypass} überbrückt, welche antiparallel zur Flussrichtung des Solarstroms geschaltet wird. Die Bypass-Diode D_{Bypass} stellt eine Sicherungseinrichtung im Photovoltaik-Modul 4 dar, über welche im Falle der Verschattung oder eines Defekts des Photovoltaik-Moduls 4 der Strom über die Bypass-Diode D_{Bypass} umgeleitet wird. Die Bypass-Diode D_{Bypass} ist üblicherweise extern am Photovoltaik-Modul 4 angeordnet. Dargestellt ist ein Ersatzschaltbild einer einzelnen Zelle des Photovoltaik-Moduls 4. Ein String 4' mehrerer Photovoltaik-Module 4 ist mit dem DC-Eingang 3 des Photovoltaik-Wechselrichters 2 verbunden. Der nachfolgende DC/DC-Wandler 5 ist als Booster ausgebildet und beinhaltet einen parallel zum DC-Eingang 3 angeordneten Boost-Schalter S_{Boost}, der normalerweise zum Aufwärtsregeln der Eingangsgleichspannung U_{DC} verwendet wird, und eine Boost-Diode D_{Boost} in Richtung des gewünschten Stromflusses. Der Zwischenkreis 6 des Photovoltaik-Wechselrichters 2 ist durch den Zwischenkreiskondensator C_{ZK} repräsentiert, an welchem die Zwischenkreisspannung U_{ZK} anliegt. Die Messeinrichtung 13 zur Bestimmung der Anlagenkapazität C_{PV} und des Isolationswiderstands Rᵢₛₒ beinhaltet den Spannungsteiler 14, welcher zumindest zwei Widerstände R₁, R₂ aufweist, wobei der Widerstand R₁ über einen Schalter Sᵢₛₒ zu- bzw. weggeschaltet werden kann. Zwischen den Widerständen R₁, R₂ am Mittelpunkt des Spannungsteilers 14 ist eine Spannungsmesseinheit 15 zur Erfassung von Messspannungen U_{Mi} am Widerstand R₂ angeordnet. Erfindungsgemäß wird der DC-Eingang 3 mit einem Eingangskurzschlussschalter S_{Boost}, der hier durch den Boost-Schalter S_{Boost} des DC/DC-Wandlers 5 gebildet ist, kurzgeschlossen. Dadurch bildet sich ein Stromkreis über die Anlagenkapazität C_{PV} und den Isolationswiderstand Rᵢₛₒ aus, gemäß welchem die Zwischenkreisspannung U_{ZK} in umgekehrter Richtung an die Photovoltaik-Module 4 bzw. den String 4' der Photovoltaik-Module 4 angelegt wird (strichliert eingezeichnet). Der Strom I fließt also entsprechend der strichliert eingezeichneten Linie in Durchlassrichtung der Bypass-Dioden D_{Bypass}. Somit kann auch in den Nachtstunden, wenn die Photovoltaik-Module 4 besonders hochohmig sind, eine zuverlässige Messung der Anlagenkapazität C_{PV} und des Isolationswiderstands Rᵢₛₒ durchgeführt werden. Dabei wird bei geschlossenem Eingangskurzschlussschalter S_{Boost} jeweils eine Messspannung U_{M1} bei geöffnetem Schalter Sᵢₛₒ des Spannungsteilers 14 und eine Messspannung U_{M2} bei geschlossenem Schalter Sᵢₛₒ des Spannungsteilers 14 erfasst. Aus den Messwerten der beiden erfassten Messspannungen U_{M1}, U_{M2} bzw. dem zeitlichen Verlauf kann die Anlagenkapazität C_{PV} und der Isolationswiderstand Rᵢₛₒ ermittelt werden.

Fig. 3 zeigt ein vereinfachtes Schaltbild eines erfindungsgemäß ausgebildeten Photovoltaik-Wechselrichters 2 mit daran angeschlossenen Photovoltaik-Modulen 4 mit integrierter Elektronik 22, sogenannten MLPE (Module-Level Power Electronic). Die Elektronik 22 beinhaltet im Ersatzschaltbild neben der Diode D_{E} und einem hochohmigen Messwiderstand R_{M} auch einen Schalter S_{E}, über welche die jeweiligen Photovoltaik-Module 4 deaktiviert werden können. Beispielsweise können die Photovoltaik-Module 4 aus Sicherheitsgründen durch Öffnen des Schalters S_{E} deaktiviert werden, um sicherzustellen, dass keine gefährlichen Gleichspannungen an den Zuleitungen zum Photovoltaik-Wechselrichter 2 anliegen. In diesem Fall könnte die Anlagenkapazität C_{PV} und allenfalls der Isolationswiderstand Rᵢₛₒ mit herkömmlichen Methoden nicht bzw. nicht zuverlässig ermittelt werden, da der Strom zur Messung der Anlagenkapazität C_{PV} und des Isolationswiderstands Rᵢₛₒ aufgrund des geöffneten Schalters S_{E} in der Elektronik 22 nicht über den String 4' an Photovoltaik-Modulen 4 fließen kann. Durch den erfindungsgemäßen Kurzschluss des DC-Eingangs 3 mit Hilfe des Eingangskurzschlussschalters S_{Boost} und die resultierende Umkehrung der Zwischenkreisspannung U_{ZK} am DC-Eingang 3 ist hier ein Stromfluss über die in der Elektronik 22 integrierten Dioden D_{E} möglich. Dadurch kann auch bei deaktivierten Photovoltaik-Modulen 4 bzw. in den Nachtstunden, in welchen die Photovoltaik-Module 4 sehr hochohmig sind, eine zuverlässige Messung der Anlagenkapazität C_{PV} und des Isolationswiderstands Rᵢₛₒ stattfinden.

In Fig. 4 ist ein vereinfachtes Schaltbild eines erfindungsgemäß ausgebildeten Photovoltaik-Wechselrichters 3 mit daran angeschlossenen Photovoltaik-Modulen 4 mit integrierter Elektronik 22 und einem daran angeschlossenen Energiespeicher 18 mit integriertem Batterietrenner 17 dargestellt. Im Übrigen gilt die Beschreibung des Photovoltaik-Wechselrichters 2 gemäß den Figuren 1 und 3. Zusätzlich wird in diesem Fall vor der Erfassung der Messspannungen U_{Mi} sichergestellt, dass der Batterietrenner 17 geschlossen ist, sodass der Energiespeicher 18 auch bei der Messung der Anlagenkapazität C_{PV} und des Isolationswiderstands Rᵢₛₒ berücksichtigt wird. Der Teil der Anlagenkapazität C_{PV,i} und des Isolationswiderstands R_{iso,i} vom Energiespeicher 18 gegen Erde PE ist symbolisch eingezeichnet. Vorteilhafterweise wird die Anlagenkapazität C_{PV} und allenfalls der Isolationswiderstand Rᵢₛₒ jeweils mit und ohne zugeschaltetem Energiespeicher 18 bestimmt. Auf diese Weise kann der Anteil des Energiespeichers 18 zur Anlagenkapazität C_{PV} und Isolationswiderstand Rᵢₛₒ getrennt bestimmt werden und ein allfälliger Isolationsfehler schneller lokalisiert werden.

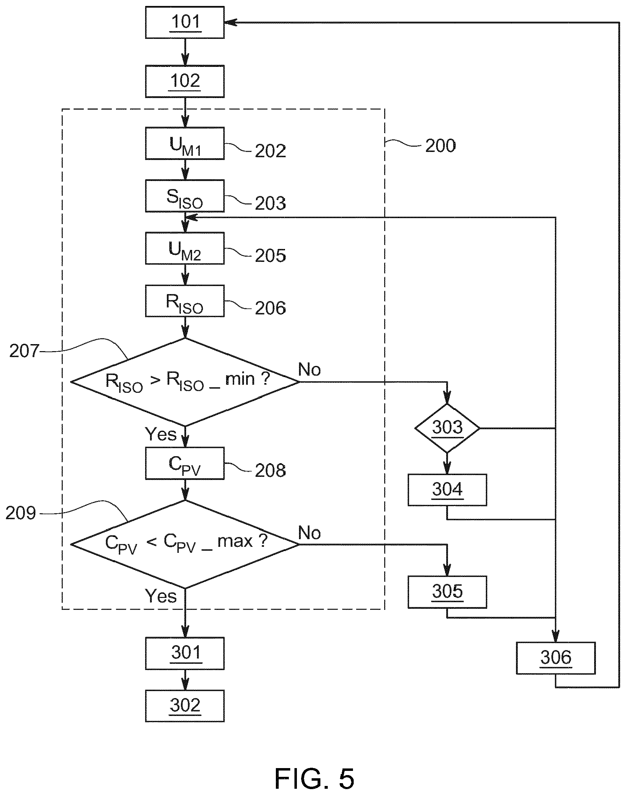

Fig. 5 zeigt ein detaillierteres Flussdiagramm der Bestimmung der relativen Anlagenkapazität C_{PV} und des relativen Isolationswiderstands Rᵢₛₒ. Nach dem Start des Verfahrens gemäß Block 101 erfolgt eine Initialisierung (Block 102), während welcher Phase auch der Eingangskurzschlussschalter S_{Boost} geschlossen wird. Der strichliert eingezeichnete Block 200 beinhaltet die Verfahrensschritte zur Bestimmung der relativen Anlagenkapazität C_{PV} und des relativen Isolationswiderstands Rᵢₛₒ, also die Überprüfung, ob die Anlagenkapazität C_{PV} unterhalb der definierten maximalen Anlagenkapazität C_{PV_max} und ob der Isolationswiderstands Rᵢₛₒ über dem definierten minimalen Isolationswiderstand R_{iso_min} liegt. Gemäß Verfahrensschritt 202 wird die erste Messspannung U_{M1} bei geöffnetem Schalter Sᵢₛₒ des Spannungsteiler 14 gemessen. Danach wird gemäß Schritt 203 der Schalter Sᵢₛₒ geschlossen. Danach (Schritt 205) wird die zweite Messspannung U_{M2} bei geschlossenem Schalter Sᵢₛₒ des Spannunsgsteiler 14 gemessen. Danach wird gemäß Schritt 206 der Isolationswiderstand Rᵢₛₒ bestimmt und gemäß Schritt 207 festgestellt, ob dieser über dem definierten minimalen Isolationswiderstand R_{iso_min} liegt. Aus dem zeitlichen Verlauf der Messspannung U_{M2} bei geschlossenem Schalter Sᵢₛₒ wird die Anlagenkapazität C_{PV} bestimmt (Schritt 208) und festgestellt, ob diese unterhalb der definierten maximalen Anlagenkapazität C_{PV_max} liegt (Block 209). Wenn sowohl der Isolationswiderstand Rᵢₛₒ als auch die Anlagenkapazität C_{PV} die entsprechenden Grenzwerte nicht unter- oder überschreiten, erfolgt gemäß Block 301 die Öffnung des Schalters Sᵢₛₒ des Spannungsteilers 14 und des Eingangskurzschlussschalters S_{Boost} und danach die Verbindung des Photovoltaik-Wechselrichters 2 mit dem Versorgungsnetz 10 und bzw. oder den Verbrauchern 11 durch Schließen des AC-Trenners 8 (Block 302).

Wenn der Isolationswiderstand Rᵢₛₒ unter dem definierten minimalen Isolationswiderstand R_{iso_min} liegt, die Abfrage 207 also ein negatives Ergebnis liefert, wird gemäß Verfahrensschritt 303 eine definierte Zeit gewartet und die Messung nach einer gewissen Zeit (Block 306) wieder gestartet und zu Verfahrensschritt 101 gesprungen. Nach einer bestimmten Anzahl von Messungen oder der Überschreitung einer bestimmten Zeit wird gemäß Block 304 eine Fehlermeldung ausgegeben und der Schalter Sᵢₛₒ des Spannungsteilers und der Eingangskurzschlusschalter S_{Boost} geöffnet. Es wird also kein ausreichend hoher Isolationswiderstand Rᵢₛₒ gemessen. Wenn die Anlagenkapazität C_{PV} die definierte maximale Anlagenkapazität C_{PV_max} überschreitet, die Abfrage 209 also ein negatives Ergebnis liefert, wird eine Fehlermeldung ausgegeben und der Schalter Sᵢₛₒ des Spannungsteilers 14 geöffnet (Block 305) und nach einer vorgegebenen Zeitspanne (Block 306) wieder zum Start (Block 101) zurückgesprungen.

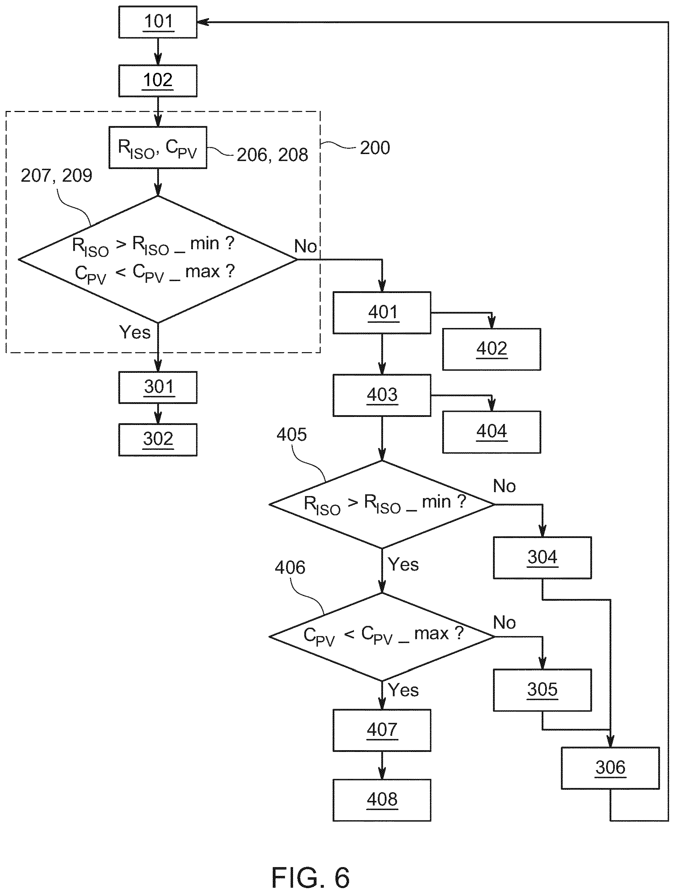

Fig. 6 zeigt das Flussdiagramm gemäß Fig. 5 bei einem Hybrid-Wechselrichter mit angeschlossenem Energiespeicher 18. Die Verfahrensschritte innerhalb des Blocks 200 sind hier der Einfachheit halber nicht so detailliert, wie in Fig. 5 dargestellt. Zusätzlich zu den in Fig. 5 beschriebenen Verfahrensschritten bei zugeschaltetem Energiespeicher 18, also geschlossenem Batterietrenner 17, wird nach der Ermittlung der relativen Anlagenkapazität C_{PV}, also der Unterschreitung der definierten maximalen Anlagenkapazität C_{PV_max} (Block 207) und des relativen Isolationswiderstands Rᵢₛₒ, also der Überschreitung des definierten minimalen Isolationswiderstands R_{iso_min} (Block 209) der Energiespeicher 18 durch Öffnen des Batterietrenners 17 getrennt und der Schalter Sᵢₛₒ des Spannungsteilers 14 geöffnet (Block 401). Im Falle eines Fehlers beim Öffnen des Batterietrenners 17 erfolgt eine Fehlermeldung entsprechend Block 402. Andernfalls wird der Isolationswiderstand Rᵢₛₒ (Block 403) und die Anlagenkapazität C_{PV} (Block 406) bestimmt und mit dem definierten minimalen Isolationswiderstand R_{iso_min} (Block 405) und der definierten maximalen Anlagenkapazität C_{PV_max} (Block 406) verglichen. Wenn die Abfragen 405 und 406 ein positives Ergebnis liefern, erfolgt gemäß Block 407 die Öffnung des Schalters Sᵢₛₒ des Spannungsteilers 14 und des Eingangskurzschlussschalters S_{Boost} und danach die Verbindung des Photovoltaik-Wechselrichters 2 ohne angeschlossenem Energiespeicher 18 an das Versorgungsnetz 10 bzw. die Verbraucher 11 durch Schließen des AC-Trenners 8 (Block 408). Wenn eine der Abfragen 405 und 406 ein negatives Ergebnis liefert, erfolgt gemäß Block 304 bzw. 305 eine Fehlermeldung und nach Abwarten einer vorgegebenen Zeit (Block 306) ein Neustart des Verfahrens zur Bestimmung der relativen Anlagenkapazität C_{PV} und allenfalls des Isolationswiderstands Rᵢₛₒ.

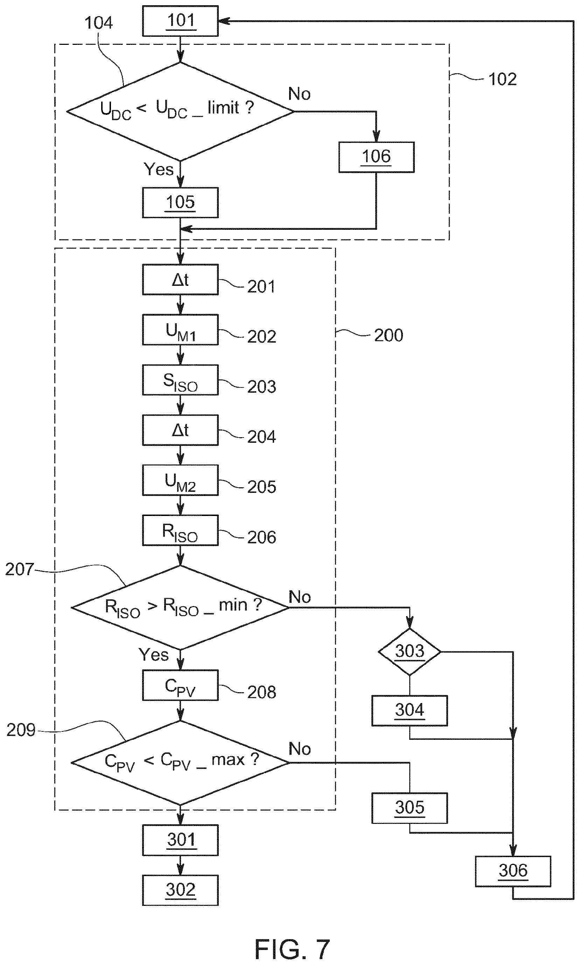

In Fig. 7 ist ein detaillierteres Flussdiagramm der Bestimmung der absoluten Anlagenkapazität C_{PV} und des absoluten Isolationswiderstands Rᵢₛₒ wiedergegeben. Die Initialisierung gemäß Block 102 ist in diesem Fall detaillierter dargestellt. Dementsprechend erfolgt gemäß Block 104 eine Messung der Spannung U_{DC} am DC-Eingang 3 des Photovoltaik-Wechselrichters 2 und ein Vergleich mit einem vorgegebenen Grenzwert U_{DC_limit} (Block 104). Ergibt der Vergleich ein positives Ergebnis, ist dies ein Anzeichen dafür, dass das Photovoltaik-Modul 4 keine Spannung liefert (z.B. während der Nachtstunden oder bei geöffnetem Schalter S_{E} der Elektronik 22 des Photovoltaik-Moduls 4) und es wird der DC-Eingang 3 mit dem Eingangskurzschlussschalter S_{Boost} kurzgeschlossen (Block 105). Andernfalls bleibt der Eingangskurzschlussschalter S_{Boost} geöffnet (Block 106) und es erfolgt die Bestimmung der absoluten Anlagenkapazität C_{PV} und des absoluten Isolationswiderstands Rᵢₛₒ ohne kurzgeschlossenem DC-Eingang 3.

Zusätzlich zu den Verfahrensschritten gemäß Fig. 5 erfolgen hier die Messungen der ersten Messspannung U_{M1} bei geöffnetem Schalter Sᵢₛₒ des Spannungsteiler 14 und der zweiten Messspannung U_{M2} bei geschlossenem Schalter Sᵢₛₒ des Spannungsteiler 14 während einer vorgegebenen Zeitspanne Δt, insbesondere 1 s bis 10 s, sodass Einschwingvorgänge abklingen können und stabile Messwerte erhalten werden (Blöcke 201 und 204). Im Übrigen verläuft die Bestimmung der Anlagenkapazität C_{PV} und des Isolationswiderstands Rᵢₛₒ wie in Fig. 5 dargestellt und beschrieben.

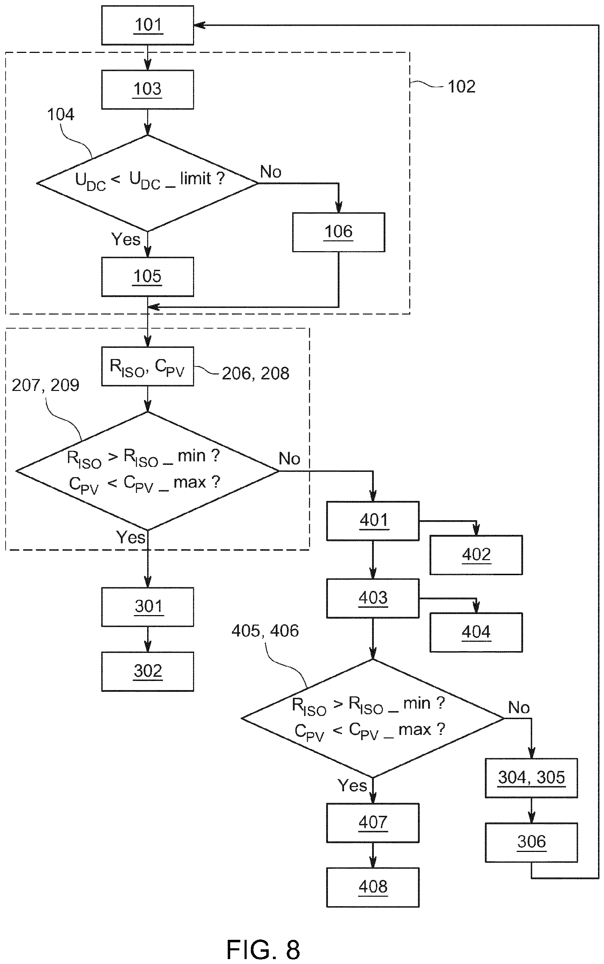

Schließlich zeigt Fig. 8 ein Flussdiagramm gemäß Fig. 7 bei einem Hybrid-Wechselrichter mit angeschlossenem Energiespeicher 18. Während der Initialisierung (Block 102) wird der Energiespeicher 18 durch Schließen des Batterietrenners 17 an den Photovoltaik-Wechselrichter 2 angeschlossen (Block 103). Danach stimmt die Initialisierung mit jener gemäß Fig. 7 überein. Die in Fig. 7 beschriebenen Wartezeiten (Blöcke 201 und 205) für die Messung der absoluten Anlagenkapazität C_{PV} und des absoluten Isolationswiderstands Rᵢₛₒ sind hier der besseren Übersichtlichkeit halber nicht dargestellt und Block 200 zusammengefasst. Wenn die Messung bei angeschlossenem Energiespeicher 18 ein positives Ergebnis liefert, erfolgt ein Zuschalten des Photovoltaik-Wechselrichters 2 an das Versorgungsnetz 10 bzw. die Verbraucher 11 mit angeschlossenem Energiespeicher 18 (Block 302), andernfalls wird die Messung bei getrenntem Energiespeicher 18 wiederholt(Blöcke 401 bis 406). Liefert diese Messung ein positives Ergebnis, so erfolgt ein Zuschalten des Photovoltaik-Wechselrichters 2 an das Versorgungsnetz 10 bzw. die Verbraucher 11 mit getrenntem Energiespeicher 18 (Block 408). Liefert auch diese Messung ein negatives Ergebnis, so erfolgt keine Zuschalten des Photovoltaik-Wechselrichters 2 an das Versorgungsnetz 10 bzw. die Verbraucher 11 und die Messung wird nach Ablauf einer vorgegebenen Zeit (Block 306) wieder neu mit Verfahrensschritt 101 begonnen.

Die vorliegende Erfindung ermöglicht eine einfache und zuverlässige Bestimmung des Isolationswiderstands Rᵢₛₒ und allenfalls der Anlagenkapazität C_{PV} einer Photovoltaik-Anlage 1 gegen Erde PE, insbesondere auch während der Nachtstunden oder bei deaktivierten Photovoltaik-Modulen 4 unter Berücksichtigung allfälliger Energiespeicher 18, welche am Photovoltaik-Wechselrichter 2 angeschlossen sind.

## Patentansprüche

1. Verfahren zur Bestimmung des Isolationswiderstands (Rᵢₛₒ) einer Photovoltaik-Anlage (1) gegen Erde (PE), mit einem Photovoltaik-Wechselrichter (2) mit zumindest einem DC-Eingang (3) zur Verbindung mit zumindest einem Photovoltaik-Modul (4) oder einem String (4') mehrerer Photovoltaik-Module (4), einem DC/DC-Wandler (5) mit einer Eingangsdiode (D_{Boost}), einem Zwischenkreis (6), einem DC/AC-Wandler (7), einem AC-Trenner (8), einem AC-Ausgang (9) zur Verbindung mit einem Versorgungsnetz (10) und bzw. oder Verbraucher (11), einer Steuereinrichtung (12), und mit einer Messeinrichtung (13) mit einem zumindest zwei Widerstände (R₁, R₂) enthaltenden Spannungsteiler (14), einem Schalter (Sᵢₛₒ) zum Zuschalten eines Widerstands (R₁) des Spannungsteilers (14) und einer Spannungsmesseinheit (15) zur Erfassung von Messspannungen (U_{Mi}) an zumindest einem Widerstand (R₂) des Spannungsteilers (14) bei geöffnetem und geschlossenem Schalter (Sᵢₛₒ) des Spannungsteilers (14) während einer Einprägung der Zwischenkreisspannung (U_{ZK}) an den DC-Eingang (3) und zur Bestimmung des Isolationswiderstands (Rᵢₛₒ) aus den erfassten Messspannungen (U_{Mi}), **dadurch gekennzeichnet, dass** die Messspannungen (U_{Mi}) bei geöffnetem AC-Trenner (8) während der DC-Eingang (3) mit einem Eingangskurzschlussschalter (S_{Boost}) kurzgeschlossen wird, wodurch die Zwischenkreisspannung (U_{ZK}) in umgekehrter Richtung an den DC-Eingang (3) angelegt wird, erfasst werden, dass jeweils eine Messspannung (U_{M1}, U_{M2}) bei geöffnetem und geschlossenem Schalter (Sᵢₛₒ) des Spannungsteilers (14) erfasst wi 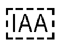 rd, und aus den Messwerten der beiden erfassten Messspannungen (U_{M1}, U_{M2}) bei geöffnetem und geschlossenen Schalter (Sᵢₛₒ) des Spannungsteilers (14) der Isolationswiderstands (Rᵢₛₒ) bestimmt wird.

2. Verfahren nach Anspruch 1, **dadurch gekennzeichnet, dass** der AC-Trenner (8) nur dann geschlossen wird, wenn ein definierter minimaler Isolationswiderstand (R_{iso_min}) überschritten wird.

3. Verfahren nach Anspruch 1 oder 2, **dadurch gekennzeichnet, dass** der Isolationswiderstand (Rᵢₛₒ) gemessen wird, indem während einer vorgegebenen Zeitspanne (Δt), insbesondere 1 s bis 10 s, die Messspannungen (U_{M1}, U_{M2}) erfasst werden.

4. Verfahren nach einem der Ansprüche 1 bis 3, **dadurch gekennzeichnet, dass** die Spannung (U_{DC}) am DC-Eingang (3) des Photovoltaik-Wechselrichters (2) gemessen wird, und bei Unterschreitung eines voreingestellten Grenzwerts (U_{DC_limit}) der Spannung (U_{DC}) der DC-Eingang (3) mit dem Eingangskurzschlussschalter (S_{Boost}) kurzgeschlossen wird.

5. Verfahren nach einem der Ansprüche 1 bis 4, **dadurch gekennzeichnet, dass** über den zeitlichen Verlauf der Messspannung (U_{M2}) nach dem Schließen des Schalters (Sᵢₛₒ) des Spannungsteilers (14) die Anlagenkapazität (C_{PV}) bestimmt wird.

6. Verfahren nach einem der Ansprüche 1 bis 5, **dadurch gekennzeichnet, dass** ein allfälliger Energiespeicher (18) durch Schließen eines Batterietrenners (17) zugeschaltet wird, und die Messspannungen (U_{M1}, U_{M2}) erfasst werden und daraus der Isolationswiderstands (Rᵢₛₒ) und allenfalls die Anlagenkapazität (C_{PV}) ermittelt wird.

7. Verfahren nach Anspruch 6, **dadurch gekennzeichnet, dass** die Überschreitung des definierten minimalen Isolationswiderstands (R_{iso_min}), der absolute Isolationswiderstand (Rᵢₛₒ), allenfalls die Unterschreitung der definierten maximalen Anlagenkapazität (C_{PV_max}) und bzw. oder allenfalls die absolute Anlagenkapazität (C_{PV}) jeweils mit und ohne zugeschaltetem Energiespeicher (18) bestimmt wird.

8. Verfahren nach einem der Ansprüche 1 bis 7, **dadurch gekennzeichnet, dass** das Überschreiten des definierten minimalen Isolationswiderstands (R_{iso_min}), der absolute Isolationswiderstand (Rᵢₛₒ), allenfalls das Unterschreiten der definierten maximalen Anlagenkapazität (C_{PV_max}), und bzw. oder allenfalls die absolute Anlagenkapazität (C_{PV}) angezeigt und bzw. oder gespeichert wird.

9. Verfahren nach einem der Ansprüche 1 bis 8, **dadurch gekennzeichnet, dass** das Überschreiten des definierten minimalen Isolationswiderstands (R_{iso_min}) , der absolute Isolationswiderstand (Rᵢₛₒ), allenfalls das Unterschreiten der definierten maximalen Anlagenkapazität (C_{PV_max}), und bzw. oder allenfalls die absolute Anlagenkapazität (C_{PV}) innerhalb einer Messzeit (tₘ) von maximal 10 s bestimmt wird.

10. Photovoltaik-Wechselrichter (2) zur Bestimmung des Isolationswiderstands (Riso) einer Photovoltaik-Anlage (1) gegen Erde (PE), mit zumindest einem DC-Eingang (3) zur Verbindung mit zumindest einem Photovoltaik-Modul (4) oder einem String (4') mehrerer Photovoltaik-Module (4), einem DC/DC-Wandler (5) mit einer Eingangsdiode (D_{Boost}), einem Zwischenkreis (6), einem DC/AC-Wandler (7), einem AC-Trenner (8), einem AC-Ausgang (9) zur Verbindung mit einem Versorgungsnetz (10) und bzw. oder Verbraucher (11), einer Steuereinrichtung (12), und mit einer Messeinrichtung (13) mit einem zumindest zwei Widerstände (R₁, R₂) enthaltenden Spannungsteiler (14), einem Schalter (Sᵢₛₒ) zum Zuschalten eines Widerstands (R₁) des Spannungsteilers (14) und einer Spannungsmesseinheit (15) zur Erfassung von Messspannungen (U_{Mi}) an zumindest einem Widerstand (R₂) des Spannungsteilers (14) bei geöffnetem und geschlossenem Schalter (Sᵢₛₒ) des Spannungsteilers (14) während einer Einprägung der Zwischenkreisspannung (U_{ZK}) an den DC-Eingang (3) und zur Bestimmung des Isolationswiderstands (Rᵢₛₒ) aus den erfassten Messspannungen (U_{Mi}), **dadurch gekennzeichnet, dass** die Messeinrichtung (13) zur Betätigung eines Eingangskurzschlussschalters (S_{Boost}) zum Kurzschließen des DC-Eingangs (3) bei geöffnetem AC-Trenner (8) ausgebildet ist, wodurch die Zwischenkreisspannung (U_{ZK}) in umgekehrter Richtung an den DC-Eingang (3) anlegbar ist, und die Messeinrichtung (13) zur Erfassung jeweils einer Messspannung (U_{M1}, U_{M2}) bei geöffnetem und geschlossenem Schalter (Sᵢₛₒ) des Spannungsteilers (14) und der Bestimmung des Isolationswiderstands (Rᵢₛₒ) aus den Messwerten der beiden erfassten Messspannungen (U_{M1}, U_{M2}) bei geöffnetem und geschlossenem Schalter (Sᵢₛₒ) des Spannungsteilers (14) eingerichtet ist.

11. Photovoltaik-Wechselrichter (2) nach Anspruch 10, **dadurch gekennzeichnet, dass** die Messeinrichtung (13) mit dem AC-Trenner (8) oder der Steuereinrichtung (12) verbunden ist, sodass der AC-Trenner (8) nur bei Überschreitung eines definierten minimalen Isolationswiderstands (R_{iso_min}) schließbar ist.

12. Photovoltaik-Wechselrichter (2) nach Anspruch 10 oder 11, **dadurch gekennzeichnet, dass** die Messeinrichtung (13) zur Messung des Isolationswiderstands (Rᵢₛₒ) ausgebildet ist, indem die Messspannungen (U_{M1}, U_{M2}) bei geöffnetem und geschlossenem Schalter (Sᵢₛₒ) des Spannungsteilers (14) während einer vorgegebenen Zeitspanne (Δt), insbesondere 1 s bis 10 s, erfassbar sind.

13. Photovoltaik-Wechselrichter (2) nach einem der Ansprüche 10 bis 12, **dadurch gekennzeichnet, dass** zumindest ein mit dem Zwischenkreis (6) verbundener Batterieanschluss (16) mit zumindest einem Batterietrenner (17) zur Verbindung mit zumindest einem Energiespeicher (18) vorgesehen ist, wobei der Batterietrenner (17) mit der Messeinrichtung (13) oder der Steuereinrichtung (12) verbunden ist, sodass der Batterietrenner (17) während der Erfassung der Messspannungen (U_{M1}, U_{M2}) betätigbar ist.

14. Photovoltaik-Wechselrichter (2) nach einem der Ansprüche 10 bis 13, **dadurch gekennzeichnet, dass** der Eingangskurzschlussschalter (S_{Boost}) durch einen vorhandenen Boost-Schalter (S_{Boost}) des als Booster ausgebildeten DC/DC-Wandlers (5) gebildet ist.

15. Photovoltaik-Wechselrichter (2) nach einem der Ansprüche 10 bis 14, **dadurch gekennzeichnet, dass** die Messeinrichtung (13) zur Messung der Anlagenkapazität (C_{PV}) und zum Vergleich der Anlagenkapazität (C_{PV}) mit einer definierten maximalen Anlagenkapazität (C_{PV_max}) ausgebildet ist, sodass der AC-Trenner (8) nur bei Unterschreitung der definierten maximalen Anlagenkapazität (C_{PV_max}) schließbar ist.
